# EUROPÄISCHE PATENTSCHRIFT

(11) **EP 1 970 468 B1**
(45) Veröffentlichungstag und Bekanntmachung des Hinweises auf die Patenterteilung: **15.07.2009**
(21) Anmeldenummer: 07103473.0
(22) Anmeldetag: 05.03.2007
(51) Int. Cl.: C23C 16/455

(54) **Beschichtungsanlage und Gasleitungssystem**
Coating assembly and gas piping system
Installation de revêtement et système de conduite de gaz

(43) Veröffentlichungstag der Anmeldung: 17.09.2008
(73) Patentinhaber: Applied Materials, Inc., Santa Clara, CA 95054 (US)
(72) Erfinder: Wieder, Stephan, 60385, Frankfurt (DE); Repmann, Tobias, 63755, Alzenau (DE)
(74) Vertreter: Lermer, Christoph

(56) Entgegenhaltungen:
- EP-A- 0 215 968
- DE-A1- 10 045 958
- US-B1- 6 189 485

## Beschreibung

### TECHNISCHES GEBIET

Die Erfindung betrifft eine Beschichtungsanlage, insbesondere eine PECVD-Beschichtungsanlage, umfassend eine Prozesskammer, und ein Gasleitungssystem zur Zufuhr und/oder zum Auslass eines Gases in bzw. aus der Prozesskammer, wobei das Gasleitungssystem wenigstens eine Einspeiseöffnung zum Einspeisen von Gas in das Gasleitungssystem bzw. zum Ableiten von Gas aus dem Gasleitungssystem, wenigstens zwei Auslassöffnungen zum Auslass des Gases aus dem Gasleitungssystem bzw. zur Einleitung des Gases in das Gasleitungssystem, sowie Leitungen aufweist, die jeweils zwischen der wenigstens einen Einspeiseöffnung und den Auslassöffnungen angeordnet sind, wobei die Leitungen derart ausgebildet sind, das der Strömungswiderstand der Leitungen zwischen der wenigstens einen Einspeiseöffnung und den Auslassöffnungen jeweils im Wesentlichen gleich groß ist. Ferner bezieht sich die Erfindung auf ein Gasleitungssystem zum Zufuhr und/oder zum Auslass eines Gases in bzw. aus einer Prozesskammer einer Beschichtungsanlage, insbesondere einer PECVD-Beschichtungsanlage, umfassend wenigstens eine Einspeiseöffnung zum Einspeisen von Gas in das Gasleitungssystem bzw. zum Ableiten von Gas aus dem Gasleitungssystem, wenigstens zwei Auslassöffnungen zum Auslassen des Gases aus dem Gasleitungssystem bzw. zur Einleitung des Gases in das Gasleitungssystem, und Leitungen, die jeweils zwischen der wenigstens einen Einspeiseöffnung und den Auslassöffnungen angeordnet sind, wobei die Leitungen derart ausgebildet sind, dass der Strömungswiderstand der Leitungen zwischen der wenigstens einen Einspeiseöffnung und den Auslassöffnungen jeweils im Wesentlichen gleich groß ist.

### STAND DER TECHNIK

Zur Beschichtung von Substraten steht eine Vielzahl von Beschichtungsverfahren zur Verfügung. Eines dieser Verfahren, das beispielsweise bei der Herstellung von Solarzellen zum Einsatz kommt, ist das sog. PECVD (Plasma Enhanced Chemical Vapor Deposition)-Verfahren, bei dem die Beschichtung mit Plasmaunterstützung aus der Gasphase erfolgt. Bei dem Verfahren werden einer Prozess- bzw. Plasmakammer Gase zugeführt. Das Plasma dieser zugeführten Gase enthält die schichtbildenden Vorprodukte, die ein Schichtwachstum auf einem Substrat ermöglichen.

Um homogene Beschichtungen zu erzielen, muss das Prozessgas den Prozessraum bzw. dem Plasmaraum möglichst homogen zugeführt werden. Aus dem Stand der Technik sind Möglichkeiten bekannt, eine homogene Gaszufuhr in eine PECVD-Prozesskammer zu erreichen. Beispielsweise wird eine Gasleitung bereitgestellt, die einer sog. "Showerhead"-Elektrode eine geeignete Mischung des Prozessgases zuführt. Die "Showerhead"-Elektrode dient zum einen als eine erste Elektrode, die mittels einer zweiten Elektrode ein Plasma bilden kann. Andererseits weist sie Auslassöffnungen auf, über die das über die Gasleitung zuströmende Prozessgas der Prozesskammer homogen zugeführt wird, d. h. das Prozessgas wird homogen auf bzw. über der Beschichtungsfläche verteilt. Eine derartige "Showerhead"-Elektrode für die Beschichtung eines kreisförmigen Substrats ist beispielsweise in der US 6,410,089 B1 beschrieben.

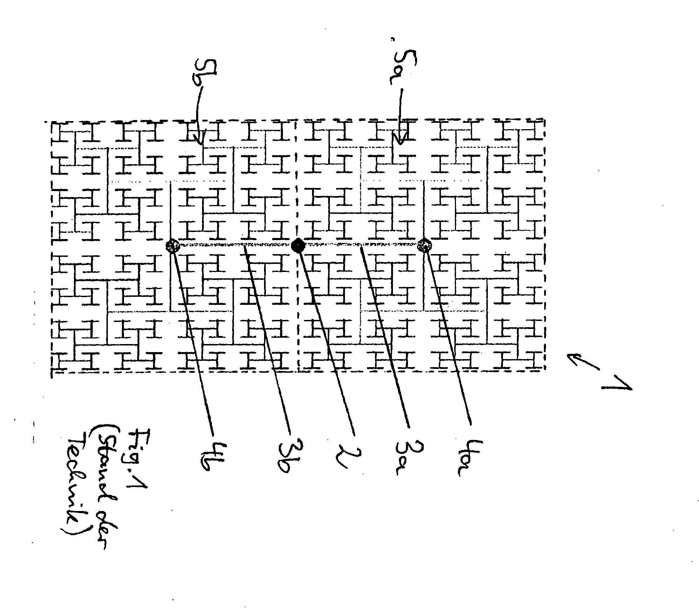

Außerdem besteht die Möglichkeit, das Prozessgas mit Hilfe einer Leitungsstruktur zu verteilen. Dabei wird das Gas von einem Einspeisepunkt über eine sich verzweigende Leitungsstruktur verteilt. Dabei kann, wie in der Figur 1 dargestellt, das Prozessgas über einen Einspeisepunkt 2 in das Gasleitungssystem 1 eingespeist werden. Das eingespeiste Prozessgas wird in zwei Richtungen gleichmäßig auf die Leitungen 3a und 3b aufgeteilt. Über Auslassöffnungen 4a bzw. 4b wird das Gas der Prozesskammer zugeführt. Durch die erste Öffnung 4a wird ein erster quadratischer Sektor 5a, der durch Strichlinien gekennzeichnet ist, mit Prozessgas beaufschlagt. Ein zweiter Sektor 5b wird durch die zweite Öffnung 4b mit Prozessgas versorgt. Um eine homogene Zufuhr zu gewährleisten, sind die Strömungswiderstände der Leitungen 3a und 3b innerhalb vorgegebener Toleranzen gleich groß.

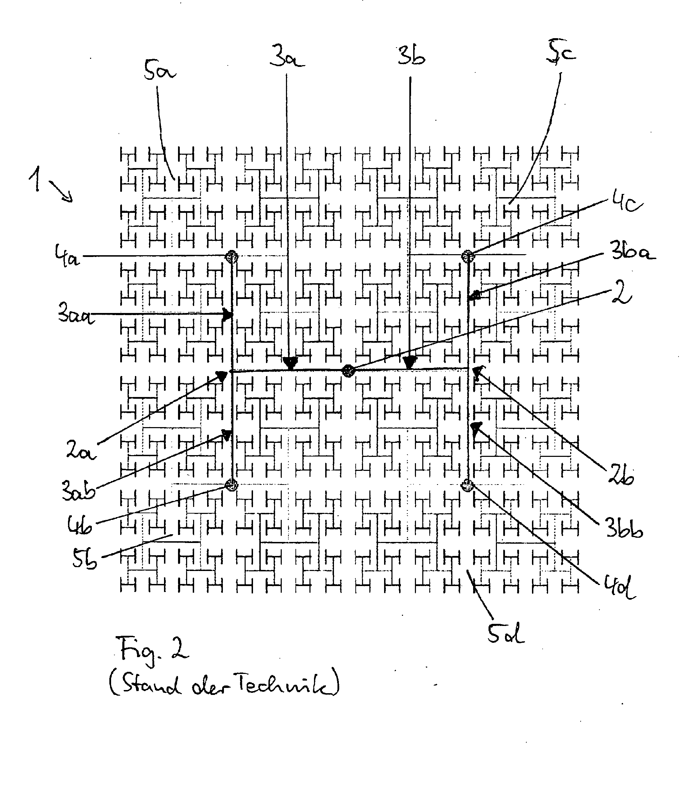

Um eine größere Fläche homogen zu beaufschlagen, kann das über eine punktförmige Einspeisungsöffnung 2 zugeführte Gas, wie in der Figur 2 skizziert, durch zwei erste Leitungsabschnitte 3a und 3b zunächst zweifach aufgeteilt werden. Das Ende der Leitungsabschnitte 3a und 3b kann wiederum jeweils als virtueller Einspeisepunkt 2a bzw. 2b angesehen werden, von dem jeweils zwei weitere Leitungsabschnitte 3aa und 3ab bzw. 3ba und 3bb ausgehen.

Die Verzweigungspunkte 2a und 2b können auch als reale Einspeisepunkte angesehen werden, wenn sie physikalisch einen Durchgang in einen anderen Kanal bilden, von dem aus die Struktur fortgesetzt wird.

Im Ergebnis werden vier Sektoren 5a, 5b, 5c und 5d mit jeweils gleicher Gasmenge beaufschlagt, sodass die in der Figur 2 dargestellte quadratische Fläche insgesamt ausreichend homogen mit Prozessgas versorgt wird.

Auf eine zweidimensionale Darstellung projiziert besteht das Gasverteilungssystem gemäß der Figur 2 aus einer H-förmigen Struktur, wobei im Mittelpunkt der H-Struktur Prozessgas eingespeist und an den vier Eckpunkten der H-Struktur entweder dem Prozessraum zugeführt wird. Selbstverständlich kann von den Eckpunkten auch eine weitere Verzweigungsebene mit einer beispielsweise wieder H-förmigen Leitungsstruktur versorgt werden. Auf diese Weise können beliebig viele Verzweigungsebenen, je nach Größe und Homogenitätsanforderungen, vorgesehen werden. Für eine gleichmäßige Verteilung des Gases im Plasmaraum über dem Substrat sind die Leitwerte der Leitungsabschnitte zwischen Anfangs- und Endpunkt innerhalb einer Verteilungsebene jeweils identisch. Dies kann beispielsweise durch eine geometrisch gleiche Ausführung der entsprechenden Leitungen realisiert werden, d.h. entsprechende Leitungsabschnitte weisen gleiche Länge und gleichen Querschnitt auf. Jede Leitung verzweigt sich beim Übergang von einer Ebene in die nächste in gleich viele Leitungen, so dass keine Maßnahmen notwendig sind, um den Strömungswiderstand zwischen dem zentralen Einspeisepunkt und jedem der Auslasspunkte konstant zu halten. Insgesamt ergibt sich dann eine Leitungsstruktur, die in verschiedenen Ebenen verläuft und von einem Einspeisepunkt in 2ⁿ/2 (n=1, 2, 3,...) neue Einspeisepunkte mündet.

Eine Struktur mit H-artigen zweifachen und vierfachen Verzweigungen ist beispielsweise in der DE10045958 A1 offenbart.

Da die (virtuellen oder realen) Einspeisepunkte 2; 2a, 2b (vgl. Figur 2) und die entsprechenden Auslasspunkte 4a, 4b, 4c und 4d in jeder Ebene ein regelmäßiges Raster bilden, lassen sich bei den bekannten Leitungsstrukturen Flächen mit einem Seitenverhältnis von 1:1, oder, wenn nur eine Hälfte einer H-Struktur realisiert wird, mit einem Seitenverhältnis von 2:1 homogen mit Prozessgas versorgen (im letztgenannten Fall wird die H-Struktur entlang der vertikalen Symmetrieachse geschnitten). Darüber hinaus wären beispielsweise noch rechteckige Beschichtungsformate mit einem Seitenverhältnis von 4:1, jedenfalls aber nur mit einem geradzahligen Seitenverhältnis, denkbar.

Regelmäßige Raster mit einem einzigen zentralen Einspeisepunkt, mit denen Flächen mit nicht geradzahligem Seitenverhältnis homogen beschichtet werden können, lassen sich mit Hilfe dieser Strukturen jedoch nicht realisieren.

### OFFENBARUNG DER ERFINDUNG

### TECHNISCHE AUFGABE

Ausgehend davon ist es die Aufgabe der vorliegenden Erfindung, eine Beschichtungsanlage bzw. ein Gasleitungssystem für eine Beschichtungsanlage bereitzustellen, mit denen in einem Prozess-/Plasmaraum eine homogene Prozessgasverteilung über der Oberfläche eines Substrats für unterschiedliche Substratformate erzeugt und somit eine homogene Beschichtung des Substrats erzielt werden kann. Insbesondere sollen rechteckige Substratformate mit anderen als geradzahligen Seitenverhältnissen über eine zentrale Einspeisung und ein regelmäßiges Raster von Gasauslasspunkten gleichmäßig versorgt werden können.

### TECHNISCHE LÖSUNG

Diese Aufgabe wird gelöst durch die Bereitstellung einer Beschichtungsanlage nach Anspruch 1 und ein Gasleitungssystem nach Anspruch 17. Vorteilhafte Ausführungsformen ergeben sich aus den Unteransprüchen.

Die erfindungsgemäße Beschichtungsanlage, insbesondere eine PECVD-Beschichtungsanlage, umfasst eine Prozesskammer, und ein Gasleitungssystem zur Zufuhr und/oder zum Auslass eines Gases in bzw. aus der Prozesskammer der Beschichtungsanlage, wobei das Gasleitungssystem wenigstens eine Einspeiseöffnung zum Einspeisen von Gas in das Gasleitungssystem bzw. zum Ableiten von Gas aus dem Gasleitungssystem, wenigstens zwei Auslassöffnungen zum Auslass des Gases aus dem Gasleitungssystem bzw. zur Einleitung des Gases in das Gasleitungssystem, und Leitungen aufweist, die jeweils zwischen der wenigstens einen Einspeiseöffnung und den Auslassöffnungen angeordnet sind, wobei die Leitungen derart ausgebildet sind, dass der Strömungswiderstand der Leitungen jeweils zwischen der wenigstens einen Einspeiseöffnung und den Auslassöffnungen im Wesentlichen gleich groß ist. Das Gasleitungssystem weist wenigstens einen Verzweigungspunkt auf, an dem ein erster Leitungsabschnitt in wenigstens drei sich an den ersten Leitungsabschnitt anschließende zweite Leitungsabschnitte mündet.

Um ein von geradzahligen Seitenverhältnissen wie 1:1 oder 2:1 eines rechteckigen Substrats abweichendes Verhältnis zu realisieren, wird erfindungsgemäß in wenigstens einer Verteilungsebene von einem virtuellen oder realen Gaseinspeisepunkt in mehr als zwei Leitungen, insbesondere direkt in drei Leitungen, verzweigt. Eine gleichmäßige Gasverteilung wird dadurch gewährleistet, dass die Gasleitwerte der verzweigten Leitungsabschnitte innerhalb jeder Verteilungsebene gleich groß sind. Die Leitwerte einer Ebene dürfen nur dann innerhalb vorgegebener Toleranzen voneinander abweichen, wenn die Leitwerte sehr groß (und damit vernachlässigbar) gegenüber den Leitwerten einer oder mehrerer anderer Verteilungsebenen sind. Sämtliche Wege zwischen der Einspeiseöffnung und den Auslassöffnungen weisen gleiche Konfiguration, das heißt ein gleiches Querschnittsprofil über ihre Länge auf. Dadurch sind die Durchflusscharakteristiken durch sämtliche Äste der Baumstruktur in solchem Maß ähnlich, dass keine zusätzlichen Maßnahmen ergriffen werden müssen, um die Strömungswiderstände aneinander anzupassen. Eine derartige Anpassung ist im Übrigen nur schwer zu berechnen und zu fertigen. Jedenfalls muss ein homogener Gasausfluss aus den Auslassöffnungen gewährleistet sein, d.h. der Gasfluss muss aus allen Auslassöffnungen mit gleicher Flussmenge (pro Zeiteinheit), gleichem Strömungsprofil, gleicher Geschwindigkeit, usw. erfolgen.

Mittels der Erfindung können insbesondere (außer 1:1) auch ungeradzahlige Formate mit Seitenverhältnissen von 3:2, 3:4 usw., homogen beschichtet werden, wobei ein regelmäßiges Raster aus Auslassöffnungen von einem einzigen Einspeisepunkt gleichmäßig versorgt wird. Die Struktur ist dabei symmetrisch zumindest dahin gehend, dass alle Leitungen bzw. Wege zwischen dem Einspeisepunkt und den Auslassöffnungen gleiche Länge, eine identische Zahl von Abzweigungen, und ein gleiches Querschnittsprofil aufweisen. Insbesondere können die am Verzweigungspunkt abgezweigten Leitungsabschnitte in gleichen Winkeln vom einspeiseöffnungsseitigen Leitungsabschnitt ausgehen, d.h. das durchströmende Gas muss am Verzweigungspunkt einen Richtungswechsel im gleichen Winkel vollziehen, durch welchen der abgezweigten Leitungsabschnitte das Gas auch strömt. Auf diese Weise wird ein identischer Strömungswiderstand in den Leitungen einer Leitungsebene erzielt.

Eine mögliche Verteilung des Gases in einer Prozesskammer über eine Fläche mit einem Seitenverhältnis von 3:2 wird beispielsweise umgesetzt, indem die rechteckige Substratfläche in beispielsweise sechs quadratische Bereiche aufgeteilt wird, die über jeweils zentral im Mittelpunkt der Quadrate liegende Auslassöffnungen versorgt werden. Ausgehend vom zentralen Einspeisepunkt für die Versorgung der Gesamtfläche können die Auslassöffnungen gleichmäßig versorgt werden, indem eine 2-fache und 3-fache Aufteilungen, die punktsymmetrisch zum Zentrum der Gesamtfläche ausgeführt sind, durchgeführt werden.

Die erfindungsgemäße Beschichtungsanlage kann besonders vorteilhaft in einem PECVD-Beschichtungsverfahren, beispielsweise zur Herstellung von Silizium-Dünnschichtsolarmodulen, eingesetzt werden. Mit dem PECVD-Verfahren werden die Silizium-Schichten der Solarzelle auf ein flaches Glassubstrat abgeschieden. Die Größe der Gläser entspricht in der Regel der Größe der Solarmodule. Aus verschiedenen Gründen ist es wünschenswert, Module mit anderen Seitenverhältnissen als 1:1 oder 2:1 herzustellen. Die in dieser Anmeldung vorgeschlagene Beschichtungsanlage trägt dem Rechnung. Die Vorteile bei der Bereitstellung von rechteckigen Modulen mit nicht geradzahligen Seitenverhältnissen besteht zum Einen in einer besseren Handhabbarkeit dieser Formate gegenüber quadratischen Modulen, so z.B. bei der Installation von Solarmodulen. Außerdem weisen gebäudeintegrierte Bauelemente meist rechteckige Formate, insbesondere aber Formate mit Seitenverhältnissen anders als 2:1, auf. Ein weiterer Vorteil nicht geradzahliger Seitenverhältnisse besteht in einer höheren Homogenität der Beschichtung in PECVD-Verfahren. Da bei größeren Längendimension der Elektrode Probleme in der Homogenität der Beschichtung entstehen, ist die Auswahl eines Seitenverhältnisses von 3:2 statt etwa 2:1 bei gleicher Beschichtungsfläche günstiger. Letztendlich entspricht das Format von 3:2 auch einem weit verbreiteten Bildformat, das praktisch gängig oder standardisiert eingesetzt wird.

Unter allen Umständen wird erfindungsgemäß ein regelmäßiges Raster für die Gaseinspeisung in den Plasmaraum bei gleichzeitiger gleichmäßiger Verteilung des Gases zur Ausbildung einer homogenen Beschichtung bereitgestellt.

Der erste Leitungsabschnitt mündet insbesondere in genau drei sich an den ersten Leitungsabschnitt anschließende zweite Leitungsabschnitte. Insgesamt entsteht eine Baumstruktur mit Verzweigungen in verschiedenen Ebenen (die Ebenen können entweder konkret etwa als schichtweise Anordnungen oder aber als abstrakte Verzweigungsebenen angesehen werden), d. h. die Leitungen verzweigen sich in Richtung der Auslassöffnungen immer weiter. Die sich verzweigenden Leitungsabschnitte sind dabei derart spiegel- und/oder punktsymmetrisch bzgl. des Verzweigungspunkts, dass keine unterschiedlichen Strömungswiderstände in den Leitungszweigen auftreten.

Umgekehrt kann das Gasleitungssystem selbstverständlich auch als System für den Abzug von Gas aus der Prozesskammer eingesetzt werden. Diese Möglichkeit soll, auch wenn im Einzelnen nicht immer beschrieben, ebenfalls im Rahmen der Erfindung geschützt werden. Die in die Prozesskammer führenden Auslassöffnungen dienen dann als Öffnungen für den Abzug des Gases aus der Prozesskammer. Das abgezogene Gas gelangt über das Leitungssystem zu der (im Rahmen dieser Anmeldung) als Einspeiseöffnung bezeichneten, zentralen Öffnung, um über diese das Gasleitungssystem zu verlassen.

Mit der wenigstens einen Einspeiseöffnung sind vorzugsweise wenigstens drei Auslassöffnungen, insbesondere genau drei Auslassöffnungen oder ein vielfaches von drei Auslassöffnungen, verbunden. Auf diese Weise können rechteckige Formate mit ungeradzahligen Seitenverhältnissen unter Bereitstellung eines regelmäßigen Versorgungsrasters homogen beschichtet werden.

Insbesondere weisen die Leitungen zwischen der Einspeiseöffnung und den Auslassöffnungen gleiche Länge auf. Zumindest sollen die Leitungen innerhalb einer Ebene mit großem Strömungswiderstand gleiche Länge, zumindest ab der Dreiteilung an einem Verzweigungs- bzw. Knotenpunkt, aufweisen. Die gleiche Länge führt dann zu einem im Wesentlichen gleich großen Strömungswiderstand zumindest in der dreigeteilten Struktur. Die Erfindung ist besonders für Systeme geeignet, bei denen der Strömungswiderstand in keiner Ebene so groß ist, dass der Strömungswiderstand in den anderen Ebenen dem gegenüber vernachlässigbar wäre.

Die Leitungen weisen vorzugsweise zwischen der Einspeiseöffnung und den Auslassöffnungen jeweils die gleiche Anzahl von Verzweigungen auf.

Die Leitungen können in wenigstens zwei Ebenen verlaufen. Dabei entsteht eine Baumstruktur mit verschiedenen Ebenen, wobei der Begriff "Ebene" abstrakt oder konkret interpretiert werden kann. Ausgehend von der zentralen Einspeiseöffnung verzweigt sich jedenfalls die Leitungsstruktur zwischen zwei Ebenen in drei Leitungsabschnitte an jedem Knotenpunkt. Die Verzweigungs- bzw. Knotenpunkte befinden sich am Übergang von einer Ebene in die nächste.

Der erste Leitungsabschnitt kann von einem ersten Punkt, insbesondere dem Einspeisepunkt, zum Verzweigungspunkt verlaufen, und die sich anschließenden wenigstens drei zweiten Leitungsabschnitte können vom Verzweigungspunkt ausgehend untereinander Winkel von 90° und/oder 180° einschließen.

Die drei vom Verzweigungspunkt ausgehenden Leitungsabschnitte können Winkel von 45°, 135° bzw. 225° mit dem ersten Leitungsabschnitt einschließen.

Das Leitungssystem weist bevorzugt eine symmetrische Struktur auf, wenigstens in einer Ebene. Insbesondere sind die abzweigenden Leitungen punktsymmetrisch zum Abzweigungs- bzw. Knotenpunkt ausgebildet.

Wenigstens ein Leitungsabschnitt kann als Ausnehmung und/oder Vertiefung in einer Platte ausgebildet, insbesondere ausgefräst, sein. Insbesondere können eine oder mehrere Leitungsebenen jeweils in eine Platte eingefräßt sein. Die Platten werden (Sandwich-artig) übereinander angeordnet, so dass eine dreidimensionale Baumstruktur entsteht.

Der erste Leitungsabschnitt ist vorzugsweise als Ausnehmung und/oder Vertiefung in einer Platte ausgebildet, insbesondere ausgefräst, und zwischen dem ersten Leitungsabschnitt und den wenigstens drei auf der dem ersten Leitungsabschnitt abgewandten Seite der Platte angeordneten zweiten Leitungsabschnitten ist eine Verbindung als Bohrung in der Platte ausgebildet. Die in den Platten eingefräßten Leitungsabschnitte werden also durch Bohrungen in den Platten mit den Leitungsabschnitten anderer Ebenen verbunden.

Die Auslassöffnungen sind insbesondere als regelmäßiges Raster über einer Gesamtfläche derart angeordnet sind, dass die Auslassöffnungen jeweils Mittelpunkte von nebeneinander angeordneten Quadraten mit jeweils gleich großer Fläche bilden, wobei die Gesamtfläche ein Rechteck mit nicht gleich langen Seiten und nicht geradzahligem Verhältnis der Seitenlängen bildet. D.h: Außer einem Quadrat (mit V=1) sollen Verhältnisse V von V=(3*2ⁿ)/(2^{m}), mit n = 0, 1, 2, 3,... und m = 0, 1, 2, 3,..., z.B. also 3:1, 3:2, 3:4, 6:1, usw. im Rahmen der Erfindung realisiert werden.

Die Anzahl der Auslassöffnungen beträgt in einer bevorzugten Ausführungsform drei oder ein ganzzahliges Vielfaches von drei. So kann eine durch drei teilbare Anzahl an Quadraten gleichmäßig mit Gas versorgt werden. Dies entspricht der Möglichkeit eines nicht geradzahligen Seitenverhältnisses. Die Anzahl N beträgt N=3*2ⁿ, mit n=0, 1,2,3...

Das Gasleitungssystem ist bevorzugt im Deckel bzw. als Deckel der Prozesskammer der Beschichtungsanlage ausgebildet.

Innerhalb der Prozesskammer können Mittel zur Erzeugung eines Plasmas, z.B. Elektroden, angeordnet sein.

Die in die Prozesskammer mündenden Auslassöffnungen können als Öffnungen in einer ein Plasma erzeugenden Elektrode ausgebildet sein. In anderen Worten kann wenigstens die Ebene des Gasleitungssystems, die die Auslassöffnungen enthält, als Flachelektrode eines PECVD-Systems ausgebildet sein. Zusammen mit einer anderen Elektrode kann sie in der Prozesskammer ein Plasma ausbilden.

Die Aufgabe wird auch gelöst durch die Bereitstellung eines Gasleitungssystem zur Zufuhr und/oder zum Auslass eines Gases in bzw. aus einer Prozesskammer einer Beschichtungsanlage, insbesondere einer PECVD-Beschichtungsanlage, umfassend wenigstens eine Einspeiseöffnung zum Einspeisen von Gas in das Gasleitungssystem bzw. zum Ableiten von Gas aus dem Gasleitungssystem, wenigstens zwei Auslassöffnungen zum Auslass des Gases aus dem Gasleitungssystem bzw. zur Einleitung des Gases in das Gasleitungssystem, und Leitungen aufweist, die jeweils zwischen der wenigstens einen Einspeiseöffnung und den Auslassöffnungen angeordnet sind, wobei die Leitungen derart ausgebildet sind, dass der Strömungswiderstand der Leitungen jeweils zwischen der wenigstens einen Einspeiseöffnung und den Auslassöffnungen im Wesentlichen gleich groß ist. Das Gasleitungssystem weist wenigstens einen Verzweigungspunkt auf, an dem ein erster Leitungsabschnitt in wenigstens drei sich an den ersten Leitungsabschnitt anschließende zweite Leitungsabschnitte mündet.

Das Gasleitungssystem kann im Rahmen der Erfindung auch ein Teilsystem eines größeren Systems sein. Die Erfindung bezieht sich im Prinzip auf 3-fache Verzweigungen in dem gattungsgemäßen Gasleitungssystem zur Versorgung einer Anzahl von drei Öffnungen (oder einem Vielfachen davon).

Verhältnisse sollen stets mit der größeren Seitenlänge im Zähler und der kleineren Seitenlänge im Nenner angegeben werden. Alle Aussagen bei invertierten Seitenverhältnissen sollen natürlich in gleicher Weise unter den Inhalt dieser Anmeldung fallen.

Die im Zusammenhang mit der Beschichtungsanlage beschriebenen Merkmale sollen auch in Bezug auf das Gasleitungssystem, die eine Komponente des erfindungsgemäßen Beschichtungssystems darstellt, beansprucht werden. Außerdem sollen im Rahmen dieser Erfindung alle möglichen Kombinationen der beschriebenen Merkmale beansprucht werden.

### KURZE BESCHREIBUNG DER ZEICHNUNGEN

Weitere Merkmale, Eigenschaften und Vorteile der vorliegenden Erfindung werden anhand der nachfolgenden Beschreibung spezieller Ausführungsbeispiele deutlich. Es zeigen die
- Figur 1: eine schematisch auf eine zweidimensionale Darstellung projizierte Draufsicht auf ein Leitungssystem gemäß dem Stand der Technik
- Figur 2: eine schematisch auf eine zweidimensionale Darstellung projizierte Draufsicht auf ein weiteres Leitungssystem gemäß dem Stand der Technik
- Figur 3: eine schematisch auf eine zweidimensionale Darstellung projizierte Draufsicht auf eine erste Ausführungsform des erfindungsgemäßen Gasleitungssystems; und
- Figur 4: eine schematische auf eine zweidimensionale Darstellung projizierte Draufsicht auf eine zweite Ausführungsform des erfindungsgemäßen Gasleitungssystems

### AUSFÜHRUNGSFORM(EN) DER ERFINDUNG

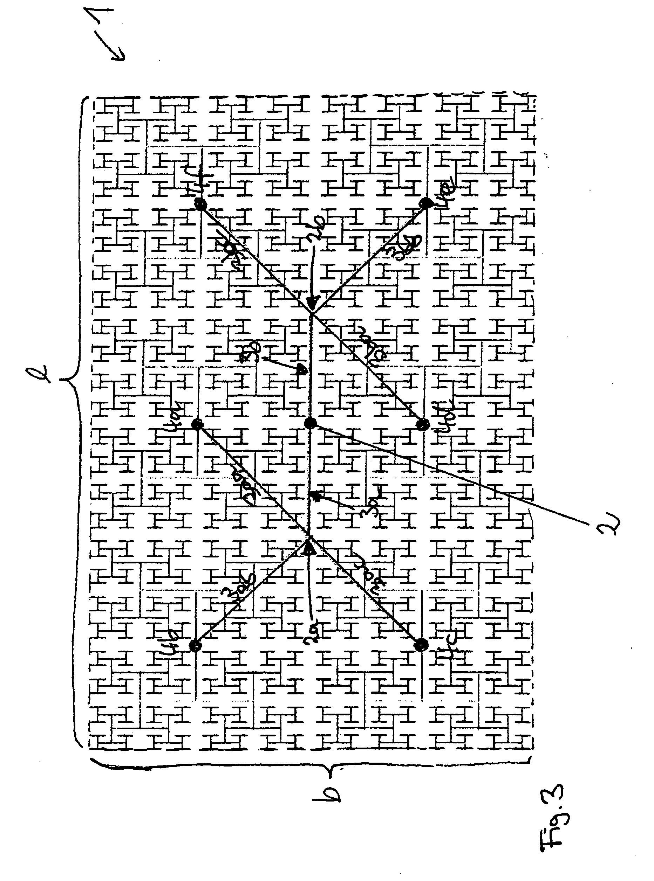

In der Figur 3 ist eine erste Ausführungsform eines Gasleitungssystems 1 für eine erfindungsgemäße PECVD-Beschichtungsanlage dargestellt. Skizziert ist dabei ein zweistufiges Verteilungssystem.

Das Prozessgas wird über eine zentrale Einspeiseöffnung 2 zugeführt. An einem ersten Knotenpunkt verteilt sich das zugeführte Gas zu gleichen Teilen in zwei Leitungen 3a und 3b, die bis zu zwei (virtuellen oder realen) Einspeisepunkten 2a bzw. 2b einen im wesentlichen gleichen Strömungswiderstand aufweisen.

An den virtuellen Einspeisepunkten 2a und 2b ist jeweils eine 3fach-Abzweigung ausgebildet. Die 3fach-Abzweigungen sind in einer Ebene unterhalb der Ebene der Leitungen 3a und 3b ausgeführt.

Die entsprechenden von den Knotenpunkten 2a bzw. 2b ausgehenden Leitungsabschnitte sind mit den Bezugszeichen 3aa, 3ab, 3ac bzw. 3ba, 3bb, 3bc bezeichnet. Sie verbinden die Abzweigungspunkte 2a bzw. 2b mit Auslassöffnungen 4a, 4b und 4c bzw. 4d, 4e und 4f.

An den Abzweigungspunkten 2a und 2b münden die Leitungsabschnitte 3aa, 3ab, 3ac bzw. 3ba, 3bb, 3bc relativ zu den Leitungsabschnitten 3a bzw. 3b in Winkeln von 45°, 135° bzw. 225° (also in 90°-Winkeln untereinander) in Richtung der Auslassöffnungen 4a, 4b und 4c bzw. 4d, 4e und 4f.

Auch diese Leitungsstücke 3aa, 3ab, 3ac, 3ba, 3bb bzw. 3bc weisen zwischen den Abzweigungspunkten 2a bzw. 2b und den jeweiligen Auslasspunkten 4a, 4b, 4c, 4d, 4e bzw. 4f gleiche Strömungswiderstände auf. Auf diese Weise wird gewährleistet, dass an den Auslasspunkten 4a, 4b, 4c, 4d, 4e und 4f jeweils gleiche Gasmengen ausströmen. Die durch Strichliniengekennzeichnete und durch das Grundraster markierte Gesamtfläche wird somit ausreichend homogen mit Gas beaufschlagt, da jede der Gasauslassöffnungen 4a, 4b, 4c, 4d, 4e und 4f den Mittelpunkt eines 1/6 der Gesamtfläche einnehmenden quadratischen Sektors bildet.

Die Punkte 4a, 4b, 4c, 4d, 4e und 4f können jedoch, statt als Auslassöffnungen in die Plasmakammer zu münden, wiederum virtuelle oder reale Einspeisepunkte bzw. Einspeiseöffnungen sein, die eine weitere sich anschließende, unter Umständen in einer weiteren Ebene angeordnete Leitungsstruktur gleichmäßig mit Gas versorgen. Es versteht sich von selbst, dass in jeder Ebene der Strömungswiderstand zwischen den virtuellen bzw. den realen Einspeisepunkten und den Auslasspunkten bzw. Auslassöffnungen im Wesentlichen gleich groß ist.

Im vorliegenden Ausführungsbeispiel sind die Leitungen 3a, 3b bzw. 3aa, 3ab, 3ac, 3ba, 3bb, 3bc jeweils in eine Platte eingefräst, wobei die Platten der Leitungen 3a, 3b bzw. 3aa, 3ab, 3ac, 3ba, 3bb, 3bc eine Baumstruktur in zwei übereinander angeordnete Ebenen bilden. Der zentrale Einspeisepunkt 2 ist als Durchgang 2 in einer die erste Leitungsebene 3a, 3b abdeckenden Abdeckplatte ausgebildet, um einen Eintritt in das Leitungssystem 3a, 3b zu ermöglichen. Die (realen oder virtuellen) Einspeisepunkte 2a und 2b sind als Durchgangsöffnungen 2a, 2b durch die die Leitungsstruktur 3a, 3b aufweisende Platte ausgebildet, um einen Übergang in das Leitungssystem 3aa, 3ab, 3ac, 3ba, 3bb, 3bc der zweiten Leitungsebene zu ermöglichen. Die Auslassöffnungen 4a, 4b, 4c, 4d, 4e und 4f sind als Durchgangsöffnungen in der Platte, in der die zweite Leitungsebene 3aa, 3ab, 3ac, 3ba, 3bb, 3bc eingefräst ist, ausgebildet. Auf diese Weise entsteht eine Sandwich-artige Plattenstruktur mit Verbindungsöffnungen zwischen den einzelnen Ebenen.

Die komplette Leitungsstruktur mit sich baumförmig verzweigenden Leitungen zur gleichmäßigen Aufteilung des Gases auf die Auslassöffnungen 4a, 4b, 4c, 4d, 4e und 4f kann als Abdeckplatte einer Prozesskammer ausgebildet sein. Das Prozessgas wird in diesem Fall von oben her homogen und gleichmäßig über der zu beschichtenden Ebene in die Prozesskammer eingeführt.

Durch die Abzweigungen der Leitungen 3a und 3b an den Knotenpunkten 2a und 2b in jeweils drei zu den Punkten 4a, 4b, 4c, 4d, 4e und 4f führende Leitungen 3a, 3ab, 3ac bzw. 3ba, 3bb, 3bc können rechteckige Flächen mit einer durch drei teilbaren Anzahl quadratischer Teilflächen gleichmäßig mit Prozessgas versorgt werden. Im vorliegenden Fall ergibt sich eine Versorgung von sechs Teilflächen, also von einem Format von 3 x 2 Teilflächen, also von einer Seitenlänge von 3:2.

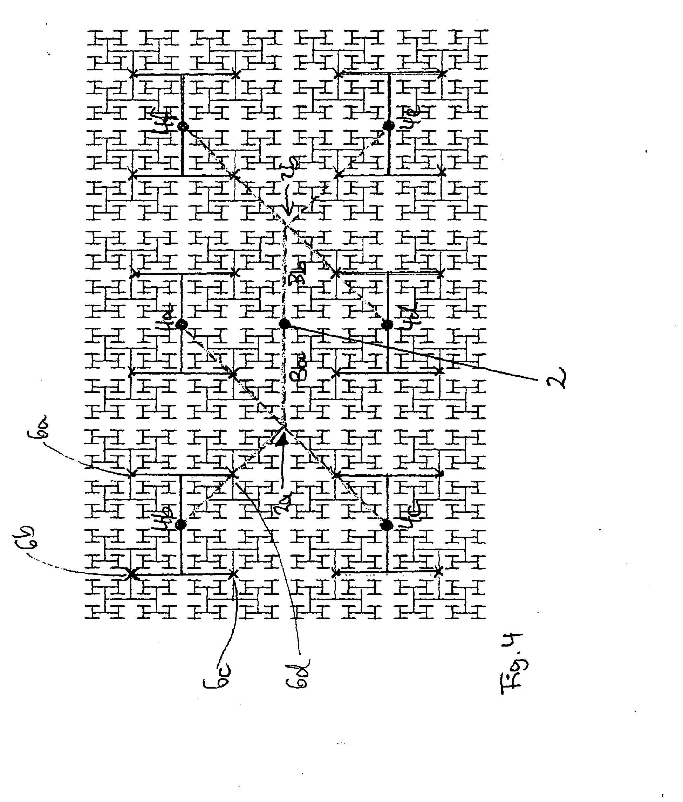

In der Figur 4 ist eine Erweiterung des Ausführungsbeispiels aus der Figur 3 mit einer weiteren Verzweigungsebene dargestellt.

Ausgehend vom Einspeisepunkt 2 teilt sich das Gas, wie in der Figur 3, in zwei Leitungsabschnitte 3a und 3b bis zu den Knotenpunkten 2a bzw. 2b auf. In den Knotenpunkten 2a, 2b findet jeweils eine 3-Teilung der Leitungen 3a, 3b hin zu den Knotenpunkten 4a, 4b, 4c, 4d, 4e bzw. 4f statt. Die Knotenpunkte 4a, 4b, 4c, 4d, 4e und 4f bilden wiederum Übergänge in eine nächste (dritte) Leitungsebene. In dieser nächsten Leitungsebene findet an jedem der Knotenpunkte 4a, 4b, 4c, 4d, 4e und 4f eine Verzweigung in eine wie in der Figur 2 dargestellte H-förmige Leitungsstruktur bis hin zu den mit einem Kreuz markierten Auslasspunkten (6a, 6b, 6c, 6d usw.) statt. Von den mit einem Kreuz markierten Auslasspunkten, die von der dritten Leitungsebene ausgehend in die Prozesskammer münden, sind lediglich die zum zentralen Knotenpunkt 4b gehörenden Auslassöffnungen 6a, 6b, 6c und 6d bezeichnet.

Die gezeigte Leitungsstruktur ist punktsymmetrisch zum Einspeisepunkt 2.

Eine Struktur mit einem Seitenverhältnis von 1/b = 3:1 = 6:2 könnte beispielsweise durch die Anordnung einer zur Figur 3 identischen (oder symmetrischen) Struktur entlang der kürzeren Seite b der durch das Gaseinlasssystem nach Figur 3 versorgten Fläche realisiert werden, ein Seitenverhältnis von 3:4 durch die Anordnung einer zur Figur 3 identischen (oder symmetrischen) Struktur entlang der längeren Seite 1 der durch das Gaseinlasssystem nach Figur 3 versorgten Fläche. Die Einspeisepunkte 2 der nebeneinander angeordneten Strukturen würden im Rahmen der Erfindung durch einen zentral zu den Punkten 2 angeordneten Einspeisepunkt versorgt werden.

Im Ausführungsbeispiel gem. der Figur 4 ergibt sich ebenfalls eine regelmäßige Verteilung der Öffnungen 6a, 6b, 6c, 6d, usw. über ein Raster mit einem Seitenlängenverhältnis von 6:4, (= 3:2), allerdings mit einer noch feineren homogeneren Aufteilung des Gases über die Gesamtfläche.

Im Prinzip sind im Rahmen der Erfindung alle Seitenverhältnisse für eine gleichmäßig zu versorgende Fläche realisierbar, bei denen die in ganzzahlige Längeneinheiten aufgeteilten Seitenlängen des Rasters in beliebigen Kombinationen durch 2 und/oder durch 3 teilbar sind. Dies ermöglicht es wiederum, Substrate mit völlig neuen Formaten (3:2, 6:2, 3:4, 3:8, usw.) zu beschichten, die unter Umständen einfacher zu handhaben oder aus technischen oder ästhetischen Gründen wünschenswert gegenüber Formatverhältnisse von 1:1 oder geradzahligen Formatverhältnissen sind.

## Patentansprüche

1. Beschichtungsanlage, insbesondere PECVD-Beschichtungsanlage, umfassend eine Prozesskammer, und
ein Gasleitungssystem (1) zur Zufuhr und/oder zum Auslass eines Gases in bzw. aus der Prozesskammer der Beschichtungsanlage, wobei das Gasleitungssystem (1) wenigstens eine Einspeiseöffnung (2) zum Einspeisen von Gas in das Gasleitungssystem (1) bzw. zum Ableiten von Gas aus dem Gasleitungssystem (1), wenigstens zwei Auslassöffnungen (4a, 4b, 4c, 4d, 4e, 4f) zum Auslass des Gases aus dem Gasleitungssystem (1) bzw. zur Einleitung des Gases in das Gasleitungssystem (1), und Leitungen (3a, 3b, 3aa, 3ab, 3ac, 3ba, 3bb, 3bc) aufweist, die jeweils zwischen der wenigstens einen Einspeiseöffnung (2) und den Auslassöffnungen (4a, 4b, 4c, 4d, 4e, 4f) angeordnet sind, wobei die Leitungen (3a, 3b, 3aa, 3ab, 3ac, 3ba, 3bb, 3bc) derart ausgebildet sind, dass der Strömungswiderstand der Leitungen (3a, 3b, 3aa, 3ab, 3ac, 3ba, 3bb, 3bc) jeweils zwischen der wenigstens einen Einspeiseöffnung (2) und den Auslassöffnungen (4a, 4b, 4c, 4d, 4e, 4f) im Wesentlichen gleich groß ist,
**dadurch gekennzeichnet dass**
das Gasleitungssystem (1) wenigstens einen Verzweigungspunkt (2a, 2b) aufweist, an dem ein erster Leitungsabschnitt (3a, 3b) in wenigstens drei sich an den ersten Leitungsabschnitt (3a, 3b) anschließende zweite Leitungsabschnitte (3aa, 3ab, 3ac, 3ba, 3bb, 3bc) mündet.

2. Beschichtungsanlage nach Anspruch 1,
**dadurch gekennzeichnet, dass**
der erste Leitungsabschnitt (3a, 3b) in genau drei sich an den ersten Leitungsabschnitt (3a, 3b) anschließende zweite Leitungsabschnitte (3aa, 3ab, 3ac, 3ba, 3bb, 3bc) mündet.

3. Beschichtungsanlage nach Anspruch 1 oder 2, **dadurch gekennzeichnet, dass**
mit der wenigstens einen Einspeiseöffnung (2) wenigstens drei Auslassöffnungen (4a, 4b, 4c, 4d, 4e, 4f), insbesondere genau drei Auslassöffnungen (4a, 4b, 4c, 4d, 4e, 4f) oder eine Anzahl N= 3*2ⁿ Auslassöffnungen (4a, 4b, 4c, 4d, 4e, 4f) , mit n=0, 1, 2, 3..., verbunden sind.

4. Beschichtungsanlage nach einem der vorhergehenden Ansprüche,
**dadurch gekennzeichnet, dass**
die Leitungen (3a, 3b, 3aa, 3ab, 3ac, 3ba, 3bb, 3bc) zwischen der Einspeiseöffnung (2) und den Auslassöffnungen (4a, 4b, 4c, 4d, 4e, 4f) gleiche Länge aufweisen.

5. Beschichtungsanlage nach einem der vorhergehenden Ansprüche,
**dadurch gekennzeichnet, dass**
die Leitungen (3a, 3b, 3aa, 3ab, 3ac, 3ba, 3bb, 3bc) zwischen der Einspeiseöffnung (2) und den Auslassöffnungen (4a, 4b, 4c, 4d, 4e, 4f) jeweils die gleiche Anzahl von Verzweigungen aufweisen.

6. Beschichtungsanlage nach einem der vorhergehenden Ansprüche,
**dadurch gekennzeichnet, dass**
die Leitungen (3a, 3b, 3aa, 3ab, 3ac, 3ba, 3bb, 3bc) in wenigstens zwei Ebenen verlaufen.

7. Beschichtungsanlage nach einem der vorhergehenden Ansprüche,
**dadurch gekennzeichnet, dass**
der erste Leitungsabschnitt (3a, 3b) von einem ersten Punkt, insbesondere dem Einspeisepunkt (2), zum Verzweigungspunkt (2a, 2b) verläuft, und die sich anschließenden wenigstens drei zweiten Leitungsabschnitte (3aa, 3ab, 3ac, 3ba, 3bb, 3bc) vom Verzweigungspunkt (2a, 2b) ausgehend untereinander Winkel von 90° und/oder 180° einschließen.

8. Beschichtungsanlage nach einem der vorhergehenden Ansprüche,
**dadurch gekennzeichnet, dass**
die drei vom Verzweigungspunkt (2a, 2b) ausgehenden Leitungsabschnitte (3aa, 3ab, 3ac, 3ba, 3bb, 3bc) Winkel von 45°, 135° bzw. 225° mit dem ersten Leitungsabschnitt (3a, 3b) einschließen.

9. Beschichtungsanlage nach einem der vorhergehenden Ansprüche,
**dadurch gekennzeichnet, dass**
das Leitungssystem (1) eine symmetrische Struktur aufweist.

10. Beschichtungsanlage nach einem der vorhergehenden Ansprüche,
**dadurch gekennzeichnet, dass**
wenigstens ein Leitungsabschnitt (3a, 3b, 3aa, 3ab, 3ac, 3ba, 3bb, 3bc) als Ausnehmung und/oder Vertiefung in einer Platte ausgebildet, insbesondere ausgefräst, ist.

11. Beschichtungsanlage nach einem der vorhergehenden Ansprüche,
**dadurch gekennzeichnet, dass**
der erste Leitungsabschnitt (3a, 3b) als Ausnehmung und/oder Vertiefung in einer Platte ausgebildet, insbesondere ausgefräst, ist, und
eine Verbindung zwischen dem ersten Leitungsabschnitt (3a, 3b) und den wenigstens drei auf der dem ersten Leitungsabschnitt abgewandten Seite der Platte angeordneten zweiten Leitungsabschnitten (3aa, 3ab, 3ac, 3ba, 3bb, 3bc) als Bohrung in der Platte ausgebildet ist.

12. Beschichtungsanlage nach einem der vorhergehenden Ansprüche,
**dadurch gekennzeichnet, dass**
die Auslassöffnungen (4a, 4b, 4c, 4d, 4e, 4f) als regelmäßiges Raster über einer Gesamtfläche derart angeordnet sind, dass die Auslassöffnungen (4a, 4b, 4c, 4d, 4e, 4f) jeweils Mittelpunkte von nebeneinander angeordneten Quadraten (5a, 5b, 5c, 5d) mit jeweils gleich großer Fläche bilden, wobei die Gesamtfläche ein Rechteck mit einem nicht geradzahligen Verhältnis V der Seitenlängen von Verhältnisse V von V=(3*2ⁿ)/(2^{m}), mit n = 0, 1, 2, 3,... und m = 0, 1, 2, 3,..., bildet.

13. Beschichtungsanlage nach einem der vorhergehenden Ansprüche,
**dadurch gekennzeichnet, dass**
die Anzahl der Auslassöffnungen (4a, 4b, 4c, 4d, 4e, 4f) drei oder ein ganzzahliges Vielfaches von drei ist.

14. Beschichtungsanlage nach einem der vorhergehenden Ansprüche,
**dadurch gekennzeichnet, dass**
das Gasleitungssystem (1) im Deckel bzw. als Deckel der Prozesskammer der Beschichtungsanlage ausgebildet ist.

15. Beschichtungsanlage nach einem der vorhergehenden Ansprüche,
**dadurch gekennzeichnet, dass**
innerhalb der Prozesskammer Mittel zur Erzeugung eines Plasmas angeordnet sind.

16. Beschichtungsanlage nach einem der vorhergehenden Ansprüche,
**dadurch gekennzeichnet, dass**
die in die Prozesskammer mündenden Auslassöffnungen (4a, 4b, 4c, 4d, 4e, 4f) als Öffnungen in einer ein Plasma erzeugenden Elektrode ausgebildet sind.

17. Gasleitungssystem (1) zur Zufuhr und/oder zum Auslass eines Gases in bzw. aus einer Prozesskammer einer Beschichtungsanlage, insbesondere einer PECVD-Beschichtungsanlage, umfassend
wenigstens eine Einspeiseöffnung (2) zum Einspeisen von Gas in das Gasleitungssystem (1) bzw. zum Ableiten von Gas aus dem Gasleitungssystem (1),
wenigstens zwei Auslassöffnungen (4a, 4b, 4c, 4d, 4e, 4f) zum Auslass des Gases aus dem Gasleitungssystem (1) bzw. zur Einleitung des Gases in das Gasleitungssystem (1), und
Leitungen (3a, 3b, 3aa, 3ab, 3ac, 3ba, 3bb, 3bc) aufweist, die jeweils zwischen der wenigstens einen Einspeiseöffnung (2) und den Auslassöffnungen (4a, 4b, 4c, 4d, 4e, 4f) angeordnet sind, wobei die Leitungen (3a, 3b, 3aa, 3ab, 3ac, 3ba, 3bb, 3bc) derart ausgebildet sind, dass der Strömungswiderstand der Leitungen (3a, 3b, 3aa, 3ab, 3ac, 3ba, 3bb, 3bc) jeweils zwischen der wenigstens einen Einspeiseöffnung (2) und den Auslassöffnungen (4a, 4b, 4c, 4d, 4e, 4f) im Wesentlichen gleich groß ist,
**dadurch gekennzeichnet dass**
das Gasleitungssystem (1) wenigstens einen Verzweigungspunkt (2a, 2b) aufweist, an dem ein erster Leitungsabschnitt (3a, 3b) in wenigstens drei sich an den ersten Leitungsabschnitt (3a, 3b) anschließende zweite Leitungsabschnitte (3aa, 3ab, 3ac, 3ba, 3bb, 3bc) mündet.

## Claims

1. Coating installation, especially a PECVD coating installation,
comprising a process chamber, and
a gas line system (1) for supplying and/or letting out a gas into or out of the process chamber of the coating installation, with the gas line system (1) having at least one feed opening (1) for feeding gas into the gas line system (1) or for removing gas from the gas line system (1), at least two outlet openings for letting out the gas from the gas line system (1) or for introducing the gas into the gas line system (1), and lines (3a, 3b, 3aa, 3ab, 3ac, 3ba, 3bb, 3bc), which are each arranged between the at least one feed opening (2) and the outlet openings (4a, 4b, 4c, 4d, 4e, 4f), with the lines (3a, 3b, 3aa, 3ab, 3ac, 3ba, 3bb, 3bc) being formed such that the flow resistance of each line (3a, 3b, 3aa, 3ab, 3ac, 3ba, 3bb, 3bc) between the at least one feed opening (2) and the outlet openings (4a, 4b, 4c, 4d, 4e, 4f) is essentially equally large,
**characterised by the fact that**
the gas line system (1) has at least one branch point (2a, 2b), at which a first line section (3a, 3b) opens into at least three second line sections (3aa, 3ab, 3ac, 3ba, 3bb, 3bc) connected to the first line section (3a, 3b).

2. Coating installation of claim 1,
**characterised by the fact that**
the first line system (3a, 3b) opens into exactly three second line sections (3aa, 3ab, 3ac, 3ba, 3bb, 3bc) connected to the first line section (3a, 3b).

3. Coating installation of claims 1 or 2,
**characterised by the fact that**
connected to the at least one feed opening (2) are at least three outlet openings (4a, 4b, 4c, 4d, 4e, 4f), especially exactly three outlet openings (4a, 4b, 4c, 4d, 4e, 4f) or a number N= 3*2ⁿ of outlet openings (4a, 4b, 4c, 4d, 4e, 4f), where n=0, 1, 2, 3...

4. Coating installation in accordance with any of the previous claims,
**characterised by the fact that**
the lines (3a, 3b, 3aa, 3ab, 3ac, 3ba, 3bb, 3bc) between the feed opening (2) and the outlet openings (4a, 4b, 4c, 4d, 4e, 4f) have the same length.

5. Coating installation of any of the previous claims,
**characterised by the fact that**
the lines (3a, 3b, 3aa, 3ab, 3ac, 3ba, 3bb, 3bc) between the feed opening (2) and the outlet openings (4a, 4b, 4c, 4d, 4e, 4f) each have the same number of branches.

6. Coating installation of any of the previous claims,
**characterised by the fact that**
the lines (3a, 3b, 3aa, 3ab, 3ac, 3ba, 3bb, 3bc) run at least into two levels.

7. Coating installation of any of the previous claims,
**characterised by the fact that**
the first line section (3a, 3b) runs from a first point, especially the feed point (2), to the branch point (2a, 2b), and the at least three connecting second line sections (3aa, 3ab, 3ac, 3ba, 3bb, 3bc), proceeding from the branch point (2a, 2b), can form angles of 90° and/or 180° among themselves.

8. Coating installation of any of the previous claims,
**characterised by the fact that**
the three line sections (3aa, 3ab, 3ac, 3ba, 3bb, 3bc) proceeding from the branch point (2a, 2b) can form angles of 45°, 135° or 225° with the first line section (3a, 3b).

9. Coating installation of any of the previous claims,
**characterised by the fact that**
the line system (1) has a symmetrical structure.

10. Coating installation of any of the previous claims,
**characterised by the fact that**
at least one line section (3a, 3b, 3aa, 3ab, 3ac, 3ba, 3bb, 3bc) is formed as a recess and/or depression in a plate, especially by milling.

11. Coating installation of any of the previous claims,
**characterised by the fact that**
the first line section (3a, 3b) is preferably formed, especially milled, as a recess and/or depression in a plate, and a connection is formed as a drill hole in the plate between the first line section (3a, 3b) and the at least three second line sections (3aa, 3ab, 3ac, 3ba, 3bb, 3bc) arranged on the side of the plate facing away from the first line section.

12. Coating installation of any of the previous claims,
**characterised by the fact that**
the outlet openings (4a, 4b, 4c, 4d, 4e, 4f) are arranged as a regular raster over a total area such that the outlet openings (4a, 4b, 4c, 4d, 4e, 4f) each form centres for contiguous squares (5a, 5b, 5c, 5d) each of the same area, with the total area forming a rectangle with a odd-numbered ratio V of the side lengths of ratios V of V=(3*2ⁿ)/(2^{m}), where n = 0, 1, 2, 3, and m = 0, 1, 2, 3....

13. Coating installation of any of the previous claims,
**characterised by the fact that**
the number of outlet openings (4a, 4b, 4c, 4d, 4e, 4f) is three or an integral multiple of three.

14. Coating installation of any of the previous claims,
**characterised by the fact that**
the gas line system (1) is formed in the cover or as the cover of the process chamber of the coating installation.

15. Coating installation of any of the previous claims,
**characterised by the fact that**
within the process chamber, means are arranged for the generation of a plasma.

16. Coating installation of any of the previous claims,
**characterised by the fact that**
the outlet openings (4a, 4b, 4c, 4d, 4e, 4f) that open into the process chamber are formed as openings in a plasma-generating electrode.

17. Gas line system (1) for supplying and/or letting out a gas into or out of a process chamber of a coating installation, especially a PECVD coating installation, comprising
at least one feed opening (2) for feeding gas into the gas line system (1) or for removing gas from the gas line system (1),
at least two outlet openings (4a, 4b, 4c, 4d, 4e, 4f) for letting out the gas from the gas line system (1) or for introducing the gas into the gas line system (1), and lines (3a, 3b, 3aa, 3ab, 3ac, 3ba, 3bb, 3bc), which are each arranged between the at least one feed opening (2) and the outlet openings (4a, 4b, 4c, 4d, 4e, 4f), with the lines (3a, 3b, 3aa, 3ab, 3ac, 3ba, 3bb, 3bc) being formed such that the flow resistance of each line (3a, 3b, 3aa, 3ab, 3ac, 3ba, 3bb, 3bc) between the at least one feed opening (2) and the outlet openings (4a, 4b, 4c, 4d, 4e, 4f) is essentially equal in magnitude,
**characterised by the fact that**
the gas line system (1) has at least one branch point (2a, 2b), at which a first line section (3a, 3b) opens into at least three second line sections (3aa, 3ab, 3ac, 3ba, 3bb, 3bc) connected to the first line section (3a, 3b).

## Revendications

1. Installation de revêtement, notamment installation de revêtement par dépôt chimique en phase vapeur assisté par plasma PECVD, comprenant une chambre de traitement et un système de conduite de gaz (1) pour amener et/ou pour évacuer un gaz entrant et/ou sortant de la chambre de traitement de l'installation de revêtement, le système de conduite de gaz (1) comportant au moins une ouverture d'alimentation (2) pour l'alimentation en gaz du système de conduite de gaz (1) et/ou pour l'évacuation du gaz hors du système de conduite de gaz (1), au moins deux ouvertures d'évacuation (4a, 4b, 4c, 4d, 4e, 4f) pour évacuer le gaz hors du système de conduite de gaz (1) et/ou pour introduire le gaz dans le système de conduite de gaz (1), et des conduites (3a, 3b, 3aa, 3ab, 3ac, 3ba, 3bb, 3bc) disposées respectivement entre l'au moins une ouverture d'alimentation (2) et les ouvertures d'évacuation (4a, 4b, 4c, 4d, 4e, 4f), les conduites (3a, 3b, 3aa, 3ab, 3ac, 3ba, 3bb, 3bc) étant configurées de telle sorte que la résistance à l'écoulement des conduites (3a, 3b, 3aa, 3ab, 3ac, 3ba, 3bb, 3bc) est respectivement pour l'essentiel égale entre l'au moins une ouverture d'alimentation (2) et les ouvertures d'évacuation (4a, 4b, 4c, 4d, 4e, 4f), **caractérisé en ce que** le système de conduite de gaz (1) comporte au moins un point de ramification (2a, 2b) au niveau duquel un premier segment de conduite (3a, 3b) débouche dans au moins trois deuxièmes segments de conduite (3aa, 3ab, 3ac, 3ba, 3bb, 3bc) raccordés au premier segment de conduite (3a, 3b).

2. Installation de revêtement selon la revendication 1, **caractérisée en ce que** le premier segment de conduite (3a, 3b) débouche dans exactement trois deuxièmes segments de conduite (3aa, 3ab, 3ac, 3ba, 3bb, 3bc) raccordés au premier segment de conduite (3a, 3b).

3. Installation de revêtement selon la revendication 1 ou 2, **caractérisée en ce qu'**au moins trois ouvertures d'évacuation (4a, 4b, 4c, 4d, 4e, 4f), notamment exactement trois ouvertures d'évacuation (4a, 4b, 4c, 4d, 4e, 4f) ou un nombre N= 3*2ⁿ ouvertures d'évacuation (4a, 4b, 4c, 4d, 4e, 4f), sont reliées à l'au moins une ouverture d'alimentation (2), avec n=0, 1, 2, 3....

4. Installation de revêtement selon l'une quelconque des revendications précédentes, **caractérisée en ce que** les conduites (3a, 3b, 3aa, 3ab, 3ac, 3ba, 3bb, 3bc) présentent des longueurs identiques entre l'ouverture d'alimentation (2) et les ouvertures d'évacuation (4a, 4b, 4c, 4d, 4e, 4f).

5. Installation de revêtement selon l'une quelconque des revendications précédentes, **caractérisée en ce que** les conduites (3a, 3b, 3aa, 3ab, 3ac, 3ba, 3bb, 3bc) comportent respectivement le même nombre de ramifications entre l'ouverture d'alimentation (2) et les ouvertures d'évacuation (4a, 4b, 4c, 4d, 4e, 4f).

6. Installation de revêtement selon l'une quelconque des revendications précédentes, **caractérisée en ce que** les conduites (3a, 3b, 3aa, 3ab, 3ac, 3ba, 3bb, 3bc) s'étendent dans au moins deux plans.

7. Installation de revêtement selon l'une quelconque des revendications précédentes, **caractérisée en ce que** le premier segment de conduite (3a, 3b) s'étend d'un premier point, notamment le point d'alimentation (2), au point de ramification (2a, 2b) et **en ce que** les au moins trois deuxièmes segments de conduite (3aa, 3ab, 3ac, 3ba, 3bb, 3bc) raccordés incluent un angle de 90° et/ou 180° l'un sur l'autre en partant du point de ramification (2a, 2b).

8. Installation de revêtement selon l'une quelconque des revendications précédentes, **caractérisée en ce que** les trois segments de conduite (3aa, 3ab, 3ac, 3ba, 3bb, 3bc) partant du point de ramification (2a, 2b) incluent un angle de 45°, 135° et/ou 225° avec le premier segment de conduite (3a, 3b).

9. Installation de revêtement selon l'une quelconque des revendications précédentes, **caractérisée en ce que** le système de conduite (1) présente une structure symétrique.

10. Installation de revêtement selon l'une quelconque des revendications précédentes, **caractérisée en ce qu'**au moins un segment de conduite (3a, 3b, 3aa, 3ab, 3ac, 3ba, 3bb, 3bc) est réalisé dans une plaque sous la forme d'un évidement et/ou d'un renfoncement, notamment par fraisage.

11. Installation de revêtement selon l'une quelconque des revendications précédentes, **caractérisée en ce que** le premier segment de conduite (3a, 3b) est réalisé dans une plaque sous la forme d'un évidement et/ou d'un renfoncement, notamment par fraisage et **en ce qu'**une jonction est réalisée dans la plaque sous la forme d'un alésage entre le premier segment de conduite (3a, 3b) et les au moins trois deuxièmes segments de conduite (3aa, 3ab, 3ac, 3ba, 3bb, 3bc) disposés sur le côté de la plaque opposé au premier segment de conduite.

12. Installation de revêtement selon l'une quelconque des revendications précédentes, **caractérisée en ce que** les ouvertures d'évacuation (4a, 4b, 4c, 4d, 4e, 4f) sont disposées sur l'ensemble de la surface sous la forme d'un quadrillage régulier, de telle sorte que les ouvertures d'évacuation (4a, 4b, 4c, 4d, 4e, 4f) forment respectivement des points centraux de carrés (5a, 5b, 5c, 5d) disposés côte à côte avec des surfaces respectivement égales, la surface d'ensemble formant un rectangle avec le rapport V non linéaire des longueurs des côtés ayant des rapports V de V=(3*2ⁿ)/(2^{m}), avec n = 0, 1, 2, 3,... et m = 0, 1, 2,3,... .

13. Installation de revêtement selon l'une quelconque des revendications précédentes, **caractérisée en ce que** le nombre d'ouvertures d'évacuation (4a, 4b, 4c, 4d, 4e, 4f) est égal à trois ou à un multiple entier de trois.

14. Installation de revêtement selon l'une quelconque des revendications précédentes, **caractérisée en ce que** le système de conduite de gaz (1) est réalisé dans le couvercle et/ou sous la forme d'un couvercle de la chambre de traitement de l'installation de revêtement.

15. Installation de revêtement selon l'une quelconque des revendications précédentes, **caractérisée en ce que** des moyens de fabrication d'un plasma sont disposés à l'intérieur de la chambre de traitement.

16. Installation de revêtement selon l'une quelconque des revendications précédentes, **caractérisée en ce que** les ouvertures d'évacuation (4a, 4b, 4c, 4d, 4e, 4f) débouchant dans la chambre de traitement prennent la forme d'ouvertures réalisées dans une électrode fabriquant un plasma.

17. Système de conduite de gaz (1) pour amener et/ou pour évacuer un gaz entrant et/ou sortant d'une chambre de traitement d'une installation de revêtement, notamment d'une installation de revêtement par dépôt chimique en phase vapeur assisté par plasma PECVD, comprenant :
au moins une ouverture d'alimentation (2) pour l'alimentation en gaz du système de conduite de gaz (1) et/ou pour l'évacuation du gaz hors du système de conduite de gaz (1) ;
au moins deux ouvertures d'évacuation (4a, 4b, 4c, 4d, 4e, 4f) pour évacuer le gaz hors du système de conduite de gaz (1) et/ou pour introduire le gaz dans le système de conduite de gaz (1), et des conduites (3a, 3b, 3aa, 3ab, 3ac, 3ba, 3bb, 3bc) disposées respectivement entre l'au moins une ouverture d'alimentation (2) et les ouvertures d'évacuation (4a, 4b, 4c, 4d, 4e, 4f), les conduites (3a, 3b, 3aa, 3ab, 3ac, 3ba, 3bb, 3bc) étant configurées de telle sorte que la résistance à l'écoulement des conduites (3a, 3b, 3aa, 3ab, 3ac, 3ba, 3bb, 3bc) est pour l'essentiel respectivement égale entre l'au moins une ouverture d'alimentation (2) et les ouvertures d'évacuation (4a, 4b, 4c, 4d, 4e, 4f) ;
**caractérisé en ce que** le système de conduite de gaz (1) comporte au moins un point de ramification (2a, 2b) au niveau duquel un premier segment de conduite (3a, 3b) débouche dans au moins trois deuxièmes segments de conduite (3aa, 3ab, 3ac, 3ba, 3bb, 3bc) raccordés au premier segment de conduite (3a, 3b).
